(19) Europäisches Patentamt / European Patent Office / Office européen des brevets

(11) **EP 4 238 216 B1**

(12) **FASCICULE DE BREVET EUROPEEN**

(45) Date de publication et mention
de la délivrance du brevet:
**05.08.2026 Bulletin 2026/32**

(21) Numéro de dépôt: **21805426.0**

(22) Date de dépôt: **29.10.2021**

(51) Classification Internationale des Brevets (IPC):
**H03K 17/955** *(2006.01)*     **H03K 17/975** *(2006.01)*

(52) Classification Coopérative des Brevets (CPC):
**H03K 17/955; H03K 17/975**

(86) Numéro de dépôt international:
**PCT/EP2021/080183**

(87) Numéro de publication internationale:
**WO 2022/090499 (05.05.2022 Gazette 2022/18)**

(54) **DISPOSITIF DE DÉTECTION DU COUPLAGE CAPACITIF ENTRE UN OBJET ET UNE SURFACE DE DÉTECTION**

VORRICHTUNG ZUR ERFASSUNG DER KAPAZITIVEN KOPPLUNG ZWISCHEN EINEM OBJEKT UND EINER ERFASSUNGSFLÄCHE

DEVICE FOR DETECTING THE CAPACITIVE COUPLING BETWEEN AN OBJECT AND A DETECTION SURFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.11.2020 FR 2011201**

(43) Date de publication de la demande:
**06.09.2023 Bulletin 2023/36**

(73) Titulaire: **FOGALE SENSORS**
**30000 Nîmes (FR)**

(72) Inventeur: **NEEL, Christian**
**30900 NÎMES (FR)**

(74) Mandataire: **IPAZ**
**Parc Les Algorithmes**
**Bâtiment Platon**
**91190 Saint Aubin (FR)**

(56) Documents cités:
**EP-A2- 2 683 084**     **US-A- 3 588 875**
**US-A1- 2002 070 729**     **US-A1- 2013 293 244**

## Description

La présente invention concerne un dispositif de détection du couplage capacitif d'un objet avec une surface de détection. Elle concerne également un appareil mettant en œuvre un tel dispositif de détection.

Le domaine de l'invention est le domaine des interfaces de détection d'objets, et en particulier des interfaces de détection pour le domaine de la robotique.

## État de la technique

La détection capacitive est une solution connue pour détecter l'approche ou le contact d'un objet, ou pour mesurer une distance par rapport à un objet ou une cible. La détection est effectuée par mesure d'un signal électrique représentatif du couplage capacitif entre une ou des électrodes de mesure et l'objet ou la cible. Cette solution a l'avantage de permettre une détection robuste et sûre.

Cependant, la détection capacitive nécessite d'équiper une surface d'électrodes de mesures depuis lesquelles les signaux électriques sont prélevés de manière individuelle ou groupée, ce qui peut être onéreux et/ou complexe. Par exemple, dans le cas d'un équipement, cela implique souvent la réalisation d'éléments d'habillages ou de coques complexes et onéreuses pour ledit équipement.

En outre, les électrodes de mesure sont sensibles à l'influence de dépôts de salissures sur leur surface, qui peuvent influencer la mesure, et peuvent poser également des problèmes de dissipation thermique, du fait de leur nature continue.

Un dispositif de détection de couplage capacitif comprenant un moyen de polarisation, une électronique de mesure et un capteur torique est connu du document EP 2 683 084 A2.

Un but de la présente invention est de remédier à au moins un des inconvénients précités.

Un autre but de la présente invention est de proposer un dispositif de détection de couplage capacitif plus facile, moins coûteux et moins onéreux à implémenter sur une surface de détection, et en particulier sur un équipement.

Un autre but de la présente invention est de proposer un dispositif de détection de couplage capacitif moins sensible aux conditions extérieures.

## Exposé de l'invention

L'invention permet d'atteindre au moins l'un de ces buts par un dispositif de détection de couplage capacitif entre au moins un objet et une surface, dite de référence, électriquement conductrice, ledit dispositif comprenant :

- au moins un moyen, dit de polarisation, prévu pour créer, entre ladite surface de référence et ledit objet à détecter, une différence de potentiel électrique alternative, dite de travail, générant un champ électrique alternatif entre ladite surface de référence et ledit objet, et

- une électronique de mesure ; ledit dispositif comprenant en outre, distinct dudit au moins un moyen de polarisation, au moins un capteur torique :

  - comportant une ouverture centrale prévue pour être traversée par ledit champ électrique alternatif qui y génère un champ magnétique circulaire, et
  - étant prévu pour fournir un signal électrique induit par ledit champ magnétique circulaire, et représentatif dudit champ électrique alternatif ;

ladite électronique de mesure étant configurée pour détecter ledit signal électrique induit fourni par ledit capteur torique.

Selon l'invention, un capteur torique est un capteur dont la forme géométrique correspond à un tore, c'est-à-dire une structure géométrique représentant un tube courbé, de section quelconque, refermé ou replié sur lui-même autour de l'ouverture centrale.

L'invention propose de détecter un objet par rapport à une surface de référence en créant une différence de potentiel alternative directement entre l'objet et ladite surface de référence. Cela permet d'éviter l'utilisation d'électrodes capacitives qui doivent être polarisées et agencées sur ladite surface de détection. Ainsi, le dispositif de détection selon l'invention est moins complexe et moins onéreux à implémenter sur une surface de référence, et en particulier sur une surface d'un équipement, telle qu'une coque, ou d'un appareil, tel qu'un robot.

De plus, selon l'invention, le signal représentatif de la distance entre l'objet et la surface de référence est déduit à partir d'un champ électrique alternatif, généré entre l'objet et la surface de référence par la différence de potentiel alternative existante entre ledit objet et ladite surface de référence, et qui, en traversant le capteur torique génère un champ magnétique circulant dans ledit capteur torique, lequel champ magnétique induisant un signal électrique, tel qu'une tension ou un courant électrique. Ainsi, le dispositif selon l'invention est moins sensible aux salissures, aux dépôts provenant de l'extérieur ou à des dissipations thermiques, comparé aux dispositifs de détection capacitive de l'état de la technique utilisant des électrodes capacitives.

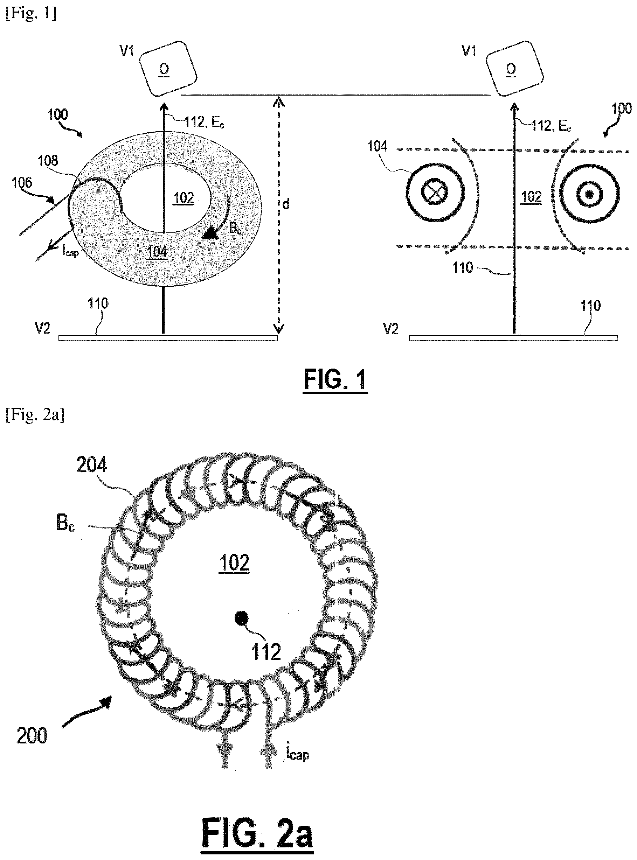

Le principe de la détection utilisée dans la présente invention est décrit plus en détail, plus bas en référence à la [Fig.1].

Dans le présent document, le terme « potentiel de masse », noté M dans la suite, désigne un potentiel de référence de l'électronique de mesure, qui peut être par exemple une masse électrique ou un potentiel de masse générale. Ce potentiel de masse peut correspondre à un potentiel de terre, ou à un autre potentiel relié ou non au potentiel de terre.

On rappelle qu'un potentiel électrique est défini par rapport à un potentiel de référence, tel que par exemple le potentiel de masse M. Il correspond donc à une différence de potentiel par rapport à ce potentiel de référence ou de masse.

Bien entendu, il peut exister entre la surface de référence et l'objet à détecter une différence de potentiel globale qui comporte également d'autres composantes, notamment fréquentielles, que les composantes de la différence de potentiel électrique alternative de travail. Cette différence de potentiel globale peut être générée par le ou les moyens de polarisation, ou d'autres moyens. La différence de potentiel électrique alternative de travail peut alors correspondre par exemple aux composantes fréquentielles, à une ou plusieurs fréquences de travail, auxquelles l'électronique de mesure est sensible, ou en d'autres termes qui ne sont pas rejetées ou ignorées par l'électronique de mesure. Dans ce cas, la différence de potentiel globale peut comprendre une composante continue et/ou des composantes fréquentielles alternatives qui ne contribuent pas à la mesure car elles ne sont pas prises en compte par l'électronique de mesure.

Bien entendu, le dispositif selon l'invention peut comprendre plusieurs capteurs toriques.

Ce mode de réalisation permet de mesurer plusieurs signaux induits permettant ainsi la mesure d'un signal induit global d'amplitude plus élevé. Il permet également de mesurer le couplage capacitif entre un ou des objets et des parties différentes de la surface de référence, par exemple d'orientation différentes.

Le dispositif selon l'invention peut notamment comprendre au moins deux capteurs toriques disposés l'un à côté de l'autre, relativement à une ou des surfaces de référence, de manière juxtaposée ou à distance l'un de l'autre. Dans ce cas, des capteurs toriques adjacents peuvent avoir une structure torique distincte.

Le dispositif selon l'invention peut également comprendre des capteurs toriques avec des portions de leur contour en commun, de sorte par exemple qu'une portion de contour délimite deux ouvertures centrales distinctes. Dans ce cas, le dispositif peut notamment comprendre une pluralité de capteurs toriques formant une structure en nid d'abeille.

Alternativement, ou en plus, le dispositif selon l'invention peut comprendre au moins deux capteurs toriques partiellement ou totalement superposés, ou empilés l'un au-dessus de l'autre, relativement à une surface de référence.

De manière générale, chaque capteur torique forme un circuit magnétique fermé autour de l'ouverture centrale.

Au moins un capteur torique forme un contour fermé ou semi-fermé, par exemple en forme d'un « C » avec un entrefer.

Au moins un capteur torique peut former un contour de forme quelconque, tel que par exemple une forme circulaire, rectangulaire ou carrée. Cette forme peut être plate, inscrite dans un plan, ou non-plate et inscrite dans une surface quelconque, telle que par exemple une surface cylindrique avec un rayon de courbure ou sphérique avec plusieurs rayons de courbure. Le capteur torique peut ainsi par exemple être positionné en regard d'une surface de référence avec une surface courbe.

De préférence, au moins un capteur torique peut être agencé selon une forme similaire à la surface de référence, ou conforme à la surface de la surface de référence, de sorte que la surface de captation qu'il délimite soit à une même distance de la surface de référence en tout point. Cela permet de s'assurer d'une bonne homogénéité du champ électrique, et ainsi d'une meilleure précision de détection.

Suivant un mode de réalisation nullement limitatif, au moins un capteur torique peut comprendre :

- un noyau torique, dit de captation, fermé ou semi-fermé, comportant l'ouverture centrale et formant un circuit magnétique fermé autour de l'ouverture centrale ; et
- au moins un bobinage électrique, dit bobinage de captation, enroulé autour dudit noyau torique de captation, dans lequel est induit le signal électrique induit.

Dans ce cas, le capteur torique comprend deux parties : d'une part le noyau torique, et d'autre part l'au moins un bobinage électrique de captation enroulé autour de ce noyau torique. Le champ électrique alternatif qui traverse l'ouverture centrale du noyau torique génère un champ magnétique, dépendant dudit champ magnétique alternatif, et circulant dans le noyau torique. Ce champ magnétique génère un signal électrique induit, sous la forme d'un courant ou d'une tension induite, dans l'au moins un bobinage de captation, qui dépend dudit champ magnétique, et donc dudit champ électrique traversant l'ouverture centrale du noyau torique.

Avantageusement, le noyau torique de captation peut être un noyau ferromagnétique, formant un circuit magnétique fermé autour de l'ouverture centrale, et autour duquel est enroulé l'au moins un bobinage de captation.

Un tel noyau ferromagnétique permet une meilleure concentration des lignes de champ magnétique et une meilleure circulation du champ magnétique circulaire, ce qui permet d'améliorer la précision et la portée de la détection. En effet, dans ce cas, la fonction de guidage du champ magnétique circulaire est essentiellement assurée par le noyau ferromagnétique, du fait de sa perméabilité magnétique relative élevée qui concentre les lignes de champ.

Ce noyau ferromagnétique peut être réalisé avec tous matériaux ayant une perméabilité magnétique relative très supérieure à 1, soit par exemple supérieure à 100, ou à 1000. Il peut être par exemple réalisé en céramique ferromagnétique, ou en ferrite. Il peut être également être réalisé dans un alliage ferromagnétique, par exemple de type mu-métal ou permalloy, ou nanocristallin.

Le noyau ferromagnétique peut avoir une section de toute forme géométrique, telle que par exemple une section circulaire, rectangulaire, ou carrée.

Le noyau ferromagnétique peut avoir un contour de toute forme géométrique, telle que par exemple circulaire, rectangulaire, ou carrée.

Il peut notamment être réalisé avec un tore de ferrite.

Il peut également être réalisé par exemple avec une ou un empilement de feuilles de mu-métal ou de permalloy découpées selon la forme du contour de l'élément torique.

Avantageusement, au moins un capteur torique peut comprendre plusieurs bobinages de captation.

Ce mode de réalisation permet une plus grande homogénéité de mesure du courant induit. Ce mode de réalisation permet aussi une plus grande flexibilité de réalisation du dispositif de détection car elle laisse une plus grande liberté de positionnement des bobinages de captation.

Au moins deux bobinages de captation peuvent être positionnés séquentiellement et/ ou de manière au moins partiellement superposée le long du contour du noyau torique de captation.

Au moins deux bobinages de captation peuvent être interfacés individuellement ou de manière groupés (par exemple en série) avec l'électronique de mesure.

Au moins deux bobinages de captation d'un capteur torique peuvent être identiques.

Au moins deux bobinages de captation d'un capteur torique peuvent être différents.

Alternativement, ou en plus, au moins un capteur torique peut comprendre, ou être formé par, un bobinage électrique, dit de captation, de forme torique, fermé sur lui-même ou semi-fermé, formant un circuit magnétique fermé autour de l'ouverture centrale, et dans lequel est induit le signal électrique induit. Par exemple, le capteur torique peut comprendre, ou être formé par, un bobinage électrique formant un solénoïde refermé sur lui-même pour former un tore, avec une pluralité de spires. Un tel bobinage peut par exemple être réalisé avec un fil bobiné.

Alternativement, ou en plus, au moins un capteur torique peut comprendre, ou être formé par, plusieurs bobinages, dits de captation, formant ensemble un contour torique, fermé sur lui-même ou semi-fermé, et formant un circuit magnétique fermé autour de l'ouverture centrale, et dans lesquels est induit le signal électrique induit.

Alternativement, ou en plus, un capteur torique peut comprendre un bobinage formant une spire unique, partiellement refermée, de forme torique et de section en forme de « C » ou de « U ». Un tel bobinage peut par exemple être réalisé dans une feuille métallique.

Ce ou ces bobinages peuvent alors être positionnés ou enroulés autour d'un espace vide, par exemple autour d'un espace rempli d'air. Ils peuvent également être positionnés autour d'un noyau réalisé dans un matériau non ferromagnétique, avec une perméabilité magnétique relative proche de 1, soit par exemple inférieure à 100. Dans ce cas, le noyau ne sert qu'au maintien mécanique de l'ensemble, et le champ magnétique est capté par le ou les bobinages électriques eux-mêmes d'une manière dépendant de leur géométrie.

Au moins un bobinage de captation d'un capteur torique peut être formé par :

- une unique spire, partielle ou totale, ou
- plusieurs spires ;

traversant l'ouverture centrale du capteur torique.

En effet, chaque bobinage de captation peut comprendre une ou plusieurs spires, ou même uniquement une spire partielle, traversant l'ouverture centrale de captation sans faire un tour complet. Bien entendu le nombre de spires détermine le courant ou la tension induite, le cas échéant.

La forme de ces spires peut être quelconque, tel que par exemple carrée, rectangulaire ou circulaire. Dans le cas d'une spire unique partielle, elle peut être par exemple en forme de « C » ou de « U ».

L'électronique de mesure peut comprendre un amplificateur de tension, ou de transimpédance, relié à au moins un capteur torique, et en particulier à au moins un bobinage de captation dudit capteur torique, et fournissant en sortie une tension ($V_s$) relative au signal électrique induit fourni par ledit capteur torique, et en particulier par le bobinage de captation dudit capteur torique.

Le signal électrique induit peut notamment comprendre ou correspondre à une tension, qui peut être mesurée avec un amplificateur de tension.

Le signal électrique induit peut également comprendre ou correspondre à un courant, qui peut être mesuré avec un amplificateur de type transimpédance. Dans ce cas, l'amplificateur de type transimpédance peut comprendre un amplificateur opérationnel (AO) avec une capacité en contre réaction entre son entrée inverseuse (-) et sa sortie. Les deux bornes du capteur torique, et en particulier du bobinage de captation dudit capteur torique, peuvent respectivement être reliées aux entrées inverseuse (-) et non-inverseuse (+) de l'AO. Ainsi, en sortie, l'AO fournit une tension, notée $V_s$, représentative du courant, noté « i », induit dans le capteur torique, et en particulier dans le bobinage de captation du capteur torique.

L'électronique de mesure peut être globalement référencée à un potentiel $V_{ref}$, qui peut être en particulier celui des alimentations de l'OA, et qui peut être laissé flottant, ou fixé par exemple au potentiel de la surface de référence, ou à un potentiel de masse.

Suivant un mode de réalisation, le dispositif de détection peut comprendre au moins une surface de référence en regard de laquelle est agencé au moins un capteur torique.

Cette surface de référence peut être réalisée en tout matériau électriquement conducteur.

Cette surface de référence peut être réalisée sous la forme d'un dépôt, d'une couche, d'une plaque, d'une pièce quelconque, ..., notamment métallique.

Cette surface de référence peut être réalisée par un élément d'habillage d'une machine ou d'un appareil, tel qu'un robot.

Cette surface de référence peut aussi être constituée de l'enveloppe ou de la paroi externe d'une machine ou d'un appareil.

Avantageusement, au moins un capteur torique peut être inscrit dans un plan, ou une surface, se conformant à la surface de référence. Cela permet d'assurer une bonne homogénéité du champ électrique traversant le capteur torique, et donc une meilleure précision de mesure.

Alternativement, ou en plus, au moins un capteur torique peut être posé sur la surface de référence. Ainsi, il est possible d'équiper toute surface de référence d'un capteur torique de manière simple et non destructive, c'est-à-dire sans avoir à modifier la surface de référence.

Alternativement, ou en plus, au moins un capteur torique peut être en regard de la surface de référence, à distance de ladite surface de référence. Ainsi, il est possible d'équiper une surface de référence d'un capteur torique, sans venir au contact de la surface de référence, ce qui permet de ne modifier aucune face de la surface de référence, qui peut par exemple accueillir d'autre éléments. Dans ce cas, le dispositif de détection comprend un élément de support ou de maintien du capteur torique à distance de la surface de référence.

Dans tous les cas, chaque capteur torique est disposé entre l'objet à détecter et la surface de référence pour être traversé par le champ électrique alternatif créé par la différence de potentiel entre la surface de référence et l'objet à détecter.

L'ouverture centrale d'au moins un capteur torique peut être traversée par la surface de référence. Ainsi, il est possible d'équiper une surface de référence par un capteur torique quelle que soit sa forme, y compris lorsque la surface de référence comporte des sommets ou des pointes.

Suivant des modes de réalisation, le moyen de polarisation peut comprendre au moins une source électrique reliée à la surface de référence et/ou à l'objet à détecter.

Suivant des modes de réalisation, le dispositif selon l'invention peut comprendre une source électrique polarisant la surface de référence à un potentiel électrique alternatif, dit de travail, correspondant à la différence de potentiel électrique alternative de travail. Dans ce cas, l'objet peut être polarisé au potentiel de masse, de manière directe, par contact, ou par couplage. On rappelle que de manière générale, un objet qui n'est pas en contact électrique direct avec un potentiel électrique particulier (objet électriquement flottant) tend à se polariser par couplage capacitif au potentiel électrique d'autres objets présents dans leur environnement, tel que par exemple la terre. Ainsi, si l'objet n'est en contact avec aucun potentiel électrique, ledit objet tend à se polariser au potentiel de masse de la terre.

Suivant des modes de réalisation, le dispositif selon l'invention peut comprendre une source électrique polarisant l'objet à détecter au potentiel de travail, correspondant à la différence de potentiel électrique alternative de travail. Dans ce cas, la surface de référence peut être polarisée au potentiel de masse.

Suivant des modes de réalisation, le dispositif selon l'invention peut comprendre :

- une première source électrique polarisant l'objet à détecter à un premier potentiel, noté $V_1$ ;
- une deuxième source électrique polarisant la surface de référence à un deuxième potentiel $V_2$;

choisies telles que la différence entre le premier potentiel alternatif et le deuxième potentiel alternatif correspond à la différence de potentiel alternative de travail.

Suivant des modes de réalisation, le moyen de polarisation peut comprendre au moins un module de polarisation torique, chaque module de polarisation torique :

- comprenant une ouverture centrale, prévue pour être disposée autour d'au moins un conducteur électrique en liaison électrique avec ladite surface de référence, et

- étant prévu pour être alimenté par un signal électrique alternatif, dit d'excitation, agencé pour générer un champ magnétique circulaire dans ledit module torique de polarisation et un potentiel vecteur champ électrique axial dans ladite ouverture centrale ;

de sorte à induire, dans ledit conducteur électrique traversant l'ouverture centrale, la différence de potentiel électrique alternative de travail.

En particulier, au moins un conducteur électrique en liaison électrique avec la surface de référence peut être, ou peut comprendre :

- une piste électrique, un fil électrique, un câble, un bus de donnée, ou
- une pièce ou une partie d'un appareil équipé par le dispositif de détection selon l'invention, tel qu'un élément d'habillage, un élément d'ossature, un segment dans le cas d'un robot ou d'un bras robotisé, un câble ou un faisceau de câbles, etc., ou
- une partie ou la totalité du corps d'un appareil équipé par le dispositif de détection selon l'invention, par exemple un segment de robot ou la totalité du robot dans la cas d'un robot ou d'un bras robotisé.

En outre, selon l'invention, le conducteur électrique peut être en liaison électrique avec la surface de référence de toutes les manières permettant de transmettre le potentiel induit par le module torique de polarisation à cette surface de référence. Cette liaison électrique peut être par exemple directe, par contact, ou réalisée au travers ou par l'intermédiaire de composants ou de circuits électroniques.

Dans le présent document, pour un module torique de polarisation :

- par « entrée du module torique de polarisation », on entend l'extrémité de l'ouverture centrale dudit au moins un module torique de polarisation se trouvant du côté opposé à la surface de référence, et
- par « sortie du module torique de polarisation », on entend l'extrémité de l'ouverture centrale dudit module de polarisation torique se trouvant du côté de à la surface de référence ;

dans la direction définie par l'au moins un conducteur relié à ladite surface de référence.

Suivant un mode de réalisation, le moyen de polarisation peut comprendre plusieurs modules toriques de polarisation, chacun alimenté par une tension alternative, de sorte à induire la différence de potentiel électrique alternative de travail dans tout conducteur traversant l'ensemble desdits éléments toriques.

Dans ce cas, lesdits modules de polarisation toriques sont disposés en cascade, ou en série, voire alignés, le long de chaque conducteur électrique qui les traverse tous.

Ce mode de réalisation permet de générer un potentiel électrique alternatif de travail élevé avec une source de tension plus basse. En effet, pour une différence de potentiel alternatif totale $\Delta V$, chaque modules de polarisation torique « j » génère une partie $\Delta V_j$ de ladite différence potentiel électrique alternatif $\Delta V$ dans chaque conducteur électrique qui le traverse de sorte que le potentiel électrique alternatif de travail correspond à la somme $\Sigma \Delta V_j$ des toutes les différences de potentiel électrique alternatif générées par lesdits modules de toriques polarisation le long de chaque conducteur qui traverse l'ensemble desdits modules toriques de polarisation les uns après les autres.

Au moins un, en particulier chaque, module torique de polarisation peut être de section circulaire, rectangulaire, carrée, ou de tout autre forme géométrique.

Au moins un module torique de polarisation peut présenter un contour de forme circulaire, ou plus généralement une forme avec une symétrie de révolution. Cela permet notamment de générer un potentiel vecteur champ magnétique avec une bonne uniformité dans l'ouverture centrale dudit module torique de polarisation.

Au moins un module torique de polarisation peut comprendre, ou être formé par, un bobinage électrique, dit d'excitation, de forme torique, fermé sur lui-même ou semi-fermé, formant un circuit magnétique fermé autour de l'ouverture centrale, et alimenté par le signal électrique d'excitation. Par exemple, le module torique de polarisation peut comprendre, ou être formé par, un bobinage électrique formant un solénoïde refermé sur lui-même pour former un tore, avec une pluralité de spires. Un tel bobinage peut par exemple être réalisé avec un fil bobiné.

Alternativement, ou en plus, au moins un module torique de polarisation peut comprendre, ou être formé par, plusieurs bobinages, dits d'excitation, formant ensemble un contour torique, fermé sur lui-même ou semi-fermé, et formant un circuit magnétique fermé autour de l'ouverture centrale, et alimentés par le signal d'excitation.

Alternativement, ou en plus, au moins un module torique de polarisation peut comprendre un bobinage formant une spire unique, partiellement fermée, de forme torique et de section en forme de « C » ou de « U ». Un tel bobinage peut par exemple être réalisé dans une feuille métallique.

Ce ou ces bobinages ayant une fonction de guidage du champ magnétique peuvent alors être positionnés ou enroulés autour d'un espace vide, par exemple autour d'un espace rempli d'air. Ils peuvent également être positionnés autour d'un noyau réalisé dans un matériau non ferromagnétique, avec une perméabilité magnétique relative proche de 1, soit par exemple inférieure à 100. Dans ce cas, le noyau ne sert qu'au maintien mécanique de l'ensemble, et le champ magnétique est guidé par le ou les bobinages d'excitation eux-mêmes.

Suivant un mode de réalisation nullement limitatif, au moins un module torique de polarisation peut comprendre :

- un noyau torique, dit d'excitation, fermé ou semi-fermé comportant l'ouverture centrale et réalisant un circuit magnétique fermé autour de l'ouverture centrale ; et
- au moins un bobinage électrique, dit bobinage d'excitation, enroulé autour dudit noyau torique d'excitation, et alimenté par un signal électrique alternatif.

Dans ce cas, le noyau torique d'excitation est de forme torique et comporte une ouverture centrale.

En particulier, le noyau torique d'excitation peut être de forme circulaire, et plus généralement une forme comportant une symétrie de révolution.

Suivant un mode de réalisation alternatif, et particulièrement avantageux, au moins un noyau torique d'excitation peut être un noyau ferromagnétique autour duquel est enroulé au moins un bobinage d'excitation.

Ce noyau ferromagnétique peut être réalisé avec tous matériaux ayant une perméabilité magnétique relative très supérieure à 1, soit par exemple supérieure à 100, ou à 1000. Il peut être par exemple réalisé en céramique ferromagnétique, ou ferrite. Il peut être également réalisé en alliage ferromagnétique, par exemple de type mu-métal ou permalloy.

Dans ce cas, l'au moins un bobinage d'excitation peut avoir une forme torique ou non. En effet, le noyau en matériau ferromagnétique de forme torique permet, du fait de sa perméabilité magnétique relative élevée, un guidage et une circulation circulaire dans le noyau torique d'excitation du champ magnétique créé par le bobinage d'excitation enroulé autour, même si le bobinage d'excitation n'a pas de forme torique.

Au moins un bobinage d'excitation peut comprendre une ou plusieurs spires.

Il peut également comprendre, en particulier lorsqu'il est mis en œuvre avec un noyau ferromagnétique, une spire partielle, qui passe à l'intérieur du noyau mais qui n'en fait pas un tour complet, par exemple un bobinage en forme de C ou de U

Suivant un mode de réalisation, au moins un module torique de polarisation peut comprendre un unique bobinage d'excitation.

Alternativement, au moins un module torique de polarisation peut comprendre plusieurs bobinages d'excitation distincts. Ce mode de réalisation permet une plus grande homogénéité de polarisation car le potentiel électrique alternatif de travail est généré de manière plus homogène dans le volume du module torique de polarisation. Ce mode de réalisation permet aussi une plus grande flexibilité de réalisation du dispositif de détection car elle laisse une plus grande liberté de positionnement des bobinages d'excitation.

Par exemple, les bobinages d'excitation d'un module torique de polarisation peuvent être distribués le long du noyau torique d'excitation selon un pas angulaire constant.

Au moins deux bobinages d'excitation d'un module torique de polarisation peuvent être alimentés par une même source électrique, ou par des sources électriques différentes.

Au moins deux bobinages d'excitation d'un module torique de polarisation peuvent être identiques. Dans ce cas lesdits bobinages d'excitation sont alimentés par une même tension alternative.

Au moins deux bobinages d'excitation d'un module torique de polarisation peuvent être différentes. Dans ce cas lesdits bobinages d'excitation sont alimentés de préférence par des tensions alternatives de même fréquence mais d'amplitudes différentes, de sorte que chaque bobinage d'excitation, pris individuellement, puisse induire une même différence de potentiel dans les conducteurs au travers de l'ouverture centrale.

Suivant une caractéristique particulièrement avantageuse, le module torique de polarisation peut comprendre, pour au moins un bobinage d'excitation, un circuit d'alimentation dudit bobinage d'excitation formant, avec ledit bobinage d'excitation, un circuit résonnant accordé à la ou une fréquence de travail de l'électronique de mesure.

Autrement dit, le ou chaque bobinage d'excitation d'au moins un module torique de polarisation peut être alimenté au travers d'un circuit résonnant formé avec ledit bobinage d'excitation. Cela permet de diminuer la puissance électrique utilisée en excitation pour générer la différence de potentiel alternative de travail. En effet, l'utilisation d'un circuit résonnant accordé à la fréquence de travail permet de diminuer le courant consommé pour une tension d'alimentation, ce qui permet de diminuer la puissance consommée.

Suivant un autre aspect de la présente invention, il est proposé un équipement pour un appareil comprenant un dispositif de détection de couplage capacitif selon l'invention.

L'équipement selon l'invention peut être un élément d'habillage tel qu'une coque, des cadres ou un treillis. Dans ces derniers cas, le ou les capteurs toriques peuvent être sous la forme de cadres.

L'équipement selon l'invention peut être un organe d'un appareil tel qu'un segment, ou une tête fonctionnelle.

Suivant des modes de réalisation, la surface de référence peut être une surface de l'équipement, conductrice de l'électricité.

Suivant des modes de réalisation, la surface de référence peut être une surface faisant partie du dispositif de détection selon l'invention, conductrice de l'électricité, et rapportée sur l'équipement, en plus ou à la place d'un élément dudit équipement, et en particulier d'un élément d'habillage dudit équipement.

Selon un autre aspect de l'invention il est proposé un appareil comportant :

- un dispositif de détection selon l'invention ; et/ou
- un équipement selon l'invention.

Suivant de modes de réalisation, la surface de référence peut être formée par une surface de l'appareil, conductrice de l'électricité.

Suivant des modes de réalisation, la surface de référence peut être une surface de l'équipement, conductrice de l'électricité, et rapportée sur ledit appareil, en plus ou à la place d'un élément dudit appareil, et en particulier d'un élément d'habillage dudit appareil.

Suivant des modes de réalisation, la surface de référence peut être une surface faisant partie du dispositif de détection selon l'invention, conductrice de l'électricité, et rapportée sur ledit appareil, en plus ou à la place d'un élément dudit appareil, et en particulier d'un élément d'habillage dudit appareil.

L'appareil selon l'invention peut être un robot ou une partie de robot, mobile ou fixe, tel que par exemple un bras robotisé, ou un robot de service.

**Description des figures et modes de réalisation**

D'autres avantages et caractéristiques apparaîtront à l'examen de la description détaillée d'un mode de réalisation nullement limitatif, et des dessins annexés sur lesquels :

- la [Fig.1] est une représentation schématique du principe de fonctionnement d'un capteur torique mis en œuvre dans un dispositif selon l'invention;
- les FIGURES 2a-2b sont des représentations schématiques d'exemples de réalisation non limitatifs d'un capteur torique pouvant être mis en œuvre dans un dispositif de détection selon l'invention ;
- la [Fig.3] est une représentation schématique d'un exemple de réalisation non limitatif d'une électronique de mesure pouvant être mise en œuvre dans un dispositif de détection selon l'invention;
- les FIGURES 4 et 5 sont des représentations schématiques d'exemples de réalisation non limitatifs d'un dispositif de détection selon l'invention ;
- la [Fig.6] est une représentation schématique du principe de fonctionnement d'un module torique de polarisation pouvant être mis en œuvre dans un dispositif selon l'invention;
- les FIGURES 7a-7d sont des représentations schématiques d'exemples de réalisation non limitatifs d'un module torique de polarisation pouvant être mis en œuvre dans un dispositif de détection selon l'invention ; et
- les FIGURES 8 et 9 sont des représentations schématiques d'exemples de réalisation non limitatifs d'un appareil selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à de l'état de la technique antérieur. Cette sélection comprend au moins une caractéristique de préférence fonctionnelle sans détails structurels, ou avec seulement une partie des détails structurels si cette partie est uniquement suffisante pour conférer un avantage technique ou pour différencier l'invention par rapport à l'état de la technique antérieure.

Sur les figures les éléments communs à plusieurs figures conservent la même référence.

La [Fig.1] est une représentation schématique du principe de fonctionnement d'un capteur torique mis en œuvre dans un dispositif selon l'invention.

Le capteur 100 de la [Fig.1] est représenté d'une part selon une vue isométrique et d'autre part selon une vue de coupe.

L'exemple donné sur la [Fig.1] n'est nullement limitatif. Le capteur torique 100 peut présenter différentes architectures, dont des exemples non limitatifs seront décrites dans la suite en référence aux FIGURES 2a-2b.

Le capteur torique 100 comporte une ouverture centrale 102.

Sur la [Fig.1], le capteur torique 100 est formé par :

- un noyau de captation 104, ferromagnétique, de section circulaire et de forme circulaire, par exemple en ferrite, délimitant l'ouverture centrale 102, et
- un bobinage de captation 106 comportant une unique spire 108.

Sur la [Fig.1], le capteur 100 est disposé entre une surface de référence 110, conductrice d'électricité, et un objet à détecter O.

Dans l'exemple représenté, et de manière nullement limitative, l'objet à détecter O est polarisé à un premier potentiel électrique noté $V_1$ et la surface de référence 110 est polarisée à un deuxième potentiel électrique $V_2$, telles que $V_2\text{-}V_1\text{=}V_T$, avec $V_T$ une différence de potentiel électrique alternative, dite de travail, non nulle, avec au moins une composante à une fréquence de travail $F_T$. Autrement dit, il existe une différence de potentiel électrique alternative égale à $V_T$ entre l'objet à détecter O et la surface de référence 110.

Dans ces conditions, il s'établit un champ électrique 112, de valeur $E_c$, entre l'objet à détecter O et la surface de référence 110. Le champ électrique 112 traverse l'ouverture centrale 102 du capteur 100. Ce champ électrique 112 varie conformément à la différence de potentiel de travail $V_T$.

**Principe de détection**

Ainsi, tel que décrit ci-dessous, le capteur 100 est agencé de sorte à permettre l'apparition d'un couplage capacitif résultant de l'établissement du champ électrique alternatif $E_c$, entre l'objet O et la surface de détection 110.

L'ouverture centrale 102 de l'élément torique délimite la zone de captation. La fonction de cet élément torique est de réaliser un circuit magnétique fermé permettant de confiner les lignes de champ magnétique résultant de la présence du champ électrique $E_c$ dans l'ouverture centrale 102.

Dans l'exemple illustré, l'élément torique se présente sous la forme d'un noyau en matériau ferromagnétique de perméabilité $\mu_r$, de forme circulaire avec un rayon moyen R et une section de surface $s_t$, et une ouverture centrale circulaire de surface S. Si on considère que la surface de référence 110 et l'objet O sont séparés par une distance d, on a, selon le théorème de Gauss-Ampère :

$$\oint_C \vec{H} \cdot \vec{dl} = \oiint_S \vec{j} \cdot \vec{ds} + \frac{\partial \vec{D}}{\partial t} \cdot \vec{ds} \ \text{(Eq. 1)}$$

l'intégrale du champ magnétique H sur un contour C entourant la surface S est égale à la somme de deux courants :

- un courant de conduction $i_c$ correspondant à l'intégrale sur cette surface de la densité de courant J qui la traverse, correspondant à un courant de conduction ;
- un courant de déplacement $i_d$ correspondant à l'intégrale sur cette surface de la dérivée temporelle du vecteur d'induction électrique D.

En l'absence de conducteur traversant la surface S, le courant de conduction $i_c$ est nul.

Le vecteur d'induction électrique D peut s'écrire, en fonction du champ électrique $E_c$ et de la permittivité diélectrique du milieu contenant la surface S, qui peut être par exemple correspondre à la permittivité diélectrique $\varepsilon_0$ de l'air ou du vide par simplicité

$$: \vec{D} = \varepsilon \vec{E_c} \ \text{(Eq. 2)}$$

Par ailleurs, on introduit le vecteur d'induction magnétique $B_c$, tel que :

$$\vec{B_c} = \mu_0 \mu_r \vec{H} \ \text{(Eq. 3)}$$

En considérant comme contour C, l'élément torique entourant la surface S, supposé sans perte de généralité de contour circulaire de rayon R, et en considérant un champ électrique $E_c$ uniforme dans la surface S et perpendiculaire à cette surface, la relation précédente peut se réécrire :

$$2\pi RB = \mu_0 \mu_r \varepsilon S \frac{\partial E_c}{\partial t} \ \text{(Eq. 4)}$$

En supposant un élément torique de section « $s_t$ » petite devant la surface S, le champ d'induction peut être considéré comme uniforme dans l'élément torique. Le flux du champ magnétique $\Phi$ correspondant dans l'élément torique est :

$$\Phi = \oiint_{s_t} \overrightarrow{B_c} \cdot \overrightarrow{ds} = \frac{\mu_0 \mu_r \varepsilon S s_t}{2\pi R} \frac{\partial E_c}{\partial t} \quad \text{(Eq. 5)}$$

Comme le champ électrique $E_c$ est généré par l'application de la différence de potentiel de travail $V_T$ entre deux éléments, à savoir la surface de référence 110 et l'objet O, séparés d'une distance d, le flux peut se réécrire :

$$\Phi = \frac{\mu_0 \mu_r \varepsilon S s_t}{2\pi R d} \frac{\partial V_T}{\partial t} \quad \text{(Eq. 6)}$$

Pour la détection, l'élément torique comprend un bobinage électrique de captation, supposé de « N » spires. Dans ces conditions, le flux $\Phi$ génère une différence de potentiel induite $V_b$, en circuit ouvert, correspondant à :

$$V_b = -N \frac{d\Phi}{dt} = -N \frac{\mu_0 \mu_r \varepsilon S s_t}{2\pi R d} \frac{\partial^2 V_T}{\partial t^2} \quad \text{(Eq. 7)}$$

Cette différence de potentiel $V_b$ peut être mesurée par une électronique de détection tel qu'un amplificateur de tension. Dans la mesure où elle dépend notamment de la distance d entre l'objet O et la surface de référence 110, elle peut être utilisée pour mesurer cette distance.

Plus généralement, il est à noter que la différence de potentiel $V_b$ peut être exprimée en fonction de la capacité C entre une électrode de mesure capacitive de même forme et de même surface S que la surface englobée par l'élément torique :

$$V_b = -NC \frac{\mu_0 \mu_r s_t}{2\pi R} \frac{\partial^2 V_T}{\partial t^2} \quad \text{(Eq. 8)}$$

Ainsi, le capteur 100 réalise bien un capteur de couplage capacitif, dans la mesure où il est sensible à la capacité qui se crée entre l'objet O et une électrode capacitive équivalente réalisée avec la surface de référence du capteur torique. Plus précisément, la surface de cette électrode capacitive équivalente correspond à la surface délimitée par l'ouverture centrale 102 du capteur torique immergé dans le champ électrique entre l'objet O et la surface de référence 110.

La détection peut également être réalisée en courant. Pour cela, on peut exprimer le flux $\Phi$ en fonction du courant de court-circuit « $i_{cap}$ » induit dans le bobinage de captation 106. Le flux dans l'élément torique circulaire de section « $s_t$ » peut s'exprimer :

$$\Phi = \oiint_{s_t} \overrightarrow{B_c} \cdot \overrightarrow{ds} = B_c s_t \quad \text{(Eq. 9)}$$

En appliquant le théorème de Gauss-Ampère en présence du courant de court-circuit $i_{cap}$ uniquement, ou de la densité de courant correspondante, on a :

$$\oint_C \overrightarrow{H} \cdot \overrightarrow{dl} = \oiint_S \overrightarrow{j_b} \cdot \overrightarrow{ds} \quad \text{(Eq. 10)}$$

ou, compte-tenu de la géométrie de l'élément torique :

$$2\pi R H = N i_{cap} \quad \text{(Eq. 11)}$$

En combinait les Eq. 9 et Eq. 11, le flux devient :

$$\Phi = \frac{\mu_0 \mu_r s_t N i_{cap}}{2\pi R} \quad (Eq.\ 12)$$

On peut alors en déduire la relation entre la tension induite à vide et le courant induit de court-circuit :

$$V_b = -N\frac{d\Phi}{dt} = -\frac{\mu_0 \mu_r s_t N^2}{2\pi R}\frac{di_{cap}}{dt} = -L\frac{di_{cap}}{dt} \quad (Eq.\ 13)$$

Avec L étant l'inductance du bobinage de captation ;

$$L = \frac{\mu_0 \mu_r s_t N^2}{2\pi R} \quad (Eq.\ 14)$$

Le courant de court-circuit induit $i_{cap}$ est alors égal à :

$$i_{cap} = \frac{1}{L} \int V_b dt = \frac{\varepsilon S}{Nd}\frac{\partial V_T}{\partial t} \quad (Eq.\ 15)$$

Le courant de court-circuit $i_{cap}$ peut également être exprimé en fonction de la capacité C entre une électrode capacitive de même forme et de même surface S que la surface englobée par l'élément torique, et l'objet en regard :

$$i_{cap} = \frac{C}{N}\frac{\partial V_T}{\partial t} \quad (Eq.\ 16)$$

L'analogie avec le capteur capacitif est encore plus évidente si on introduit le courant de conduction $i_c$ :

$$i_{cap} = \frac{i_c}{N} \quad (Eq.\ 17)$$

Le courant mesuré « $i_{cap}$ » sur le bobinage de captation correspond donc au courant de conduction $i_c$ d'un capteur capacitif équivalent, en prenant en compte un rapport de transformation lié au nombre de spires du bobinage de captation.

Il est à noter que cette analogie exprime le fait que le courant de déplacement entre des électrodes soumises à une différence de potentiel doit être égal au courant de conduction dans des conducteurs reliant ces mêmes électrodes. Le capteur torique introduit entre l'objet à détecter O et la surface de référence 110 réalise ainsi un capteur de courant de déplacement tel qu'il est défini par le théorème de Gauss-Ampère.

L'objet O et la surface de référence 110 peuvent être à des potentiels électriques quelconques, séparés par la différence de potentiel de travail $V_T$.

En particulier, l'objet peut être à un potentiel de masse générale M, et la surface de référence 110 polarisée à un potentiel de travail $V_T$ par rapport à ce potentiel de masse M. Cela permet de détecter par exemple des objets quelconques.

Alternativement, la surface de référence 110 peut être à un potentiel de masse générale M, et l'objet polarisé à un potentiel de travail $V_T$ par rapport à ce potentiel de masse M. Cela permet de détecter par exemple des objets particuliers, configurés comme des émetteurs.

De manière générale, le capteur torique permet de détecter tous types d'objets détectables par un capteur capacitif de l'art antérieur.

Suivant des modes de mise en œuvre :

- l'objet à détecter O peut être ou comprendre un objet quelconque, de préférence électriquement conducteur, ou tout objet détectable par couplage capacitif, tel que par exemple des objets diélectriques avec une permittivité diélectrique élevée ;
- l'objet à détecter O peut être ou comprendre une électrode ou un objet déterminé, par exemple dans un capteur selon l'invention destiné à mesurer une distance entre deux éléments.

L'architecture du capteur torique 102, représenté à la [Fig.1], n'est nullement limitative et est donnée à titre d'exemple.

La [Fig.2a] est une représentation schématique, vue de dessus, d'un autre exemple de réalisation non limitatif d'un capteur torique pouvant être mis en œuvre dans un dispositif de détection selon l'invention.

Le capteur torique 200, représenté sur la [Fig.2a], comprend un bobinage électrique de captation 204.

Le bobinage captation 204 est en forme de tore, fermé. En particulier, le bobinage de captation 204 une forme comportant une symétrie de révolution, en particulier circulaire. Alternativement, le bobinage captation 204 peut être en forme de tore, semi-fermé, par exemple en forme « C ».

Le bobinage de captation 204 présente une section circulaire. Alternativement, le bobinage de captation peut présenter une section triangulaire, carrée, rectangulaire, etc.

Le bobinage de captation 204 forme un circuit magnétique fermé autour de l'ouverture centrale 102, et dans lequel est induit le signal électrique induit icap.

Par exemple, le bobinage de captation 204 peut comprendre, ou être formé par, un bobinage électrique formant un solénoïde refermé sur lui-même pour former un tore, avec une pluralité de spires. Un tel bobinage peut par exemple être réalisé avec un fil bobiné.

Dans l'exemple représenté sur la [Fig.2a], le capteur torique 200 ne comporte pas de noyau autour duquel est enroulé un bobinage de captation et consiste en un bobinage de captation. Autrement dit, le bobinage de captation est enroulé autour de l'air.

Suivant une alternative, le capteur torique 200 peut comporter un noyau autour duquel est enroulé le bobinage de captation 204. Dans ce cas, le noyau peut être réalisé dans un matériau ferromagnétique, ou dans un matériau qui n'est pas ferromagnétique.

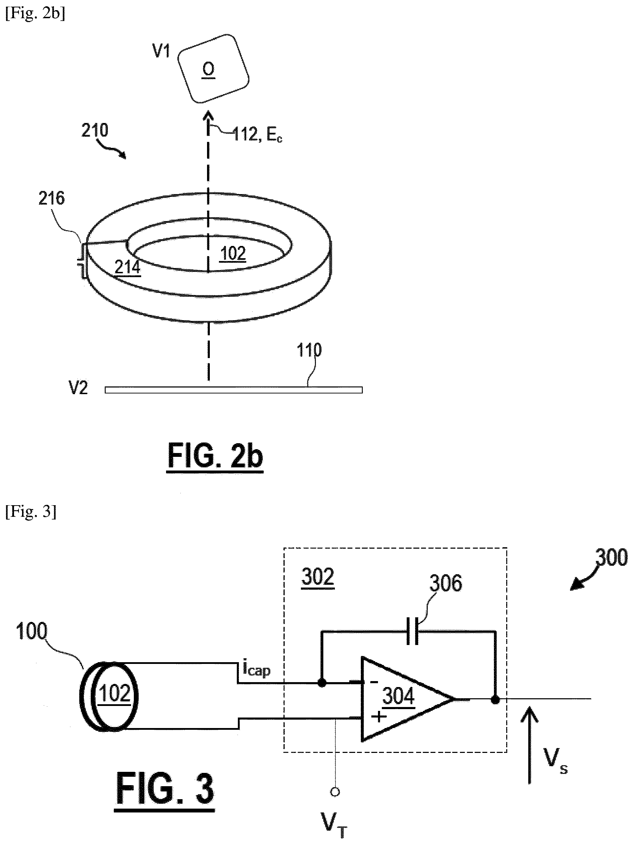

La [Fig.2b] est une représentation schématique d'un autre exemple de réalisation non limitatif d'un capteur torique pouvant être mis en œuvre dans un dispositif de détection selon l'invention.

Le capteur torique 210 de la [Fig.2b] comprend un noyau ferromagnétique 214 autour duquel est enroulé un bobinage de captation 216.

Dans l'exemple illustré, ce bobinage comprend une unique spire.

Dans les exemples représentés, chaque bobinage de captation enroulé autour d'un noyau torique comprend une unique spire. Bien entendu, au moins un bobinage de captation peut comprendre plus d'une spire.

Dans la suite, la référence 100 est utilisée pour désigner un capteur torique, qui peut être l'un quelconque des capteurs toriques décrits en référence aux FIGURES 1, 2a-2b, ou plus généralement un capteur torique répondant au principe décrit en référence à la [Fig.1].

La [Fig.3] est une représentation schématique d'un exemple de réalisation non limitatif d'une électronique de mesure pouvant être mise en œuvre dans un dispositif de détection selon l'invention.

L'électronique de mesure 300, représentée sur la [Fig.3], peut être utilisée avec tout capteur torique selon l'invention et en particulier avec l'un quelconque des capteurs représentés sur les FIGURES 1, 2a-2b.

L'électronique de mesure comprend un amplificateur de transimpédance 302 permettant de mesurer le courant de court-circuit $i_{cap}$ aux bornes du capteur torique 100, et en particulier aux bornes d'au moins bobinage de captation dudit capteur torique 100.

Dans le mode de réalisation illustré, cet amplificateur de transimpédance 302 comprend un amplificateur opérationnel (AO) 304 avec une capacité 306 en contre réaction entre son entrée inverseuse (-) et sa sortie. Les deux bornes du bobinage de captation sont respectivement reliées aux entrées inverseuse (-) et (+) de l'AO 304. On obtient ainsi en sortie de l'AO une tension $V_s$ représentative du courant $i_{cap}$ circulant dans le bobinage de captation.

L'électronique de mesure 300 peut en outre comprendre un module de mesure pour mesurer la tension $V_s$ ou une grandeur proportionnelle à ladite tension.

L'électronique de mesure peut être globalement référencée à un potentiel qui peut être celui de ses alimentations et qui peut être laissé flottant, ou fixé par exemple au potentiel de la surface de référence, correspondant au potentiel ou à la différence de potentiel de travail $V_T$ dans l'exemple illustré, ou encore à un potentiel de masse M.

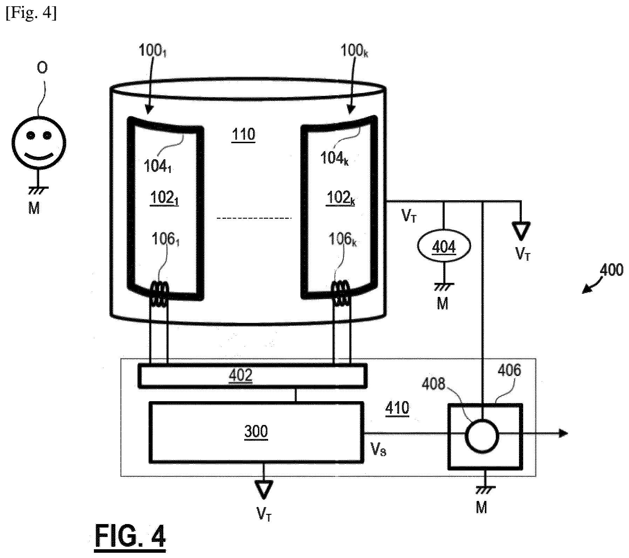

La [Fig.4] est une représentation schématique d'un exemple de réalisation non limitatif d'un dispositif de détection selon l'invention.

Le dispositif de détection 400, représenté sur la [Fig.4], peut mettre en œuvre l'un quelconque des capteurs toriques décrits plus haut. Dans l'exemple représenté, le dispositif met en œuvre des capteurs toriques 100 de la [Fig.1].

Le dispositif de détection comprend « k » capteurs toriques $100_l$-$100_k$, avec $k \geq 1$, également désignés par les références $100_i$ et 100 dans la suite. Les capteurs $100_l$-$100_k$ peuvent être identiques ou différents. Chaque capteur torique $100_i$ peut être l'un quelconque des capteurs décrits plus haut en référence aux FIGURES 1, 2a-2b.

Chaque capteur torique $100_i$ est disposé en regard de la surface de référence 110 conductrice d'électricité. Chaque capteur $100_i$ peut être disposé sur la surface de référence 110, à proximité ou à distance de la surface de référence 110, par tout moyen connu.

La surface de référence 110 peut faire partie du dispositif 400. Alternativement, la surface de référence 110 peut ne pas faire partie du dispositif 400. Dans ce cas, la surface de référence 110 peut être la surface d'un équipement pour un appareil, tel qu'un élément d'habillage, ou une surface d'un appareil tel que la surface d'un segment de robot par exemple.

Le dispositif 400 comprend une électronique de mesure configurée pour détecter un signal électrique induit fourni par chaque capteur torique $100_i$, tel que par exemple l'électronique de mesure 300 de la [Fig.3]. L'électronique de mesure 300 est reliée à chaque capteur torique $100_i$ et en particulier au(x) bobinage(s) de captation de chaque capteur torique $100_i$. Pour ce faire le dispositif 400 peut comprendre un moyen de scrutation 402, tel qu'un switch, reliant l'électronique de mesure 300 à chaque capteur torique $100_i$ à tour de rôle.

Le dispositif 400 comprend en outre une source électrique 404 fournissant la différence de potentiel alternative de travail $V_T$ à la surface de référence 110 pour polariser ladite surface de référence 110 au potentiel $V_T$. Dans ce cas, l'objet à détecter O est polarisé au potentiel de masse générale, tel que le potentiel de terre M. Alternativement, la source électrique 404 peut polariser l'objet à détecter O au potentiel $V_T$. Suivant encore une autre alternative, le dispositif selon l'invention peut comprendre deux sources électriques, l'une polarisant l'objet à détecter au potentiel $V_1$ et l'autre polarisant la surface de référence 110 au potentiel $V_2$, choisies telles que $V_2 - V_1 = V_T$.

En outre, le dispositif 400 comprend un étage de détection 406 prévu pour mesurer une donnée relative à la tension $V_s$ fournie par l'électronique de mesure 300. En particulier, l'étage de détection 406 peut comprendre, entres autres, un démodulateur synchrone 408 démodulant la tension $V_s$ en utilisant comme porteuse la tension $V_T$ fournie par la source électrique 404. Ainsi, l'étage de détection 406 fournit une grandeur relative à la tension $V_s$, en particulier une donnée relative au couplage capacitif entre la surface de référence 110 et l'objet O, et encore plus particulièrement une donnée relative à la distance entre l'objet O et la surface de référence 110.

De manière nullement limitative, l'étage de détection 406, l'électronique de mesure 300 et le moyen de scrutation 402 forment une électronique de détection 410 qui peut se présenter sous la forme d'un ou plusieurs blocs et qui peut être réalisés par des composants numériques et/ou des composants analogiques.

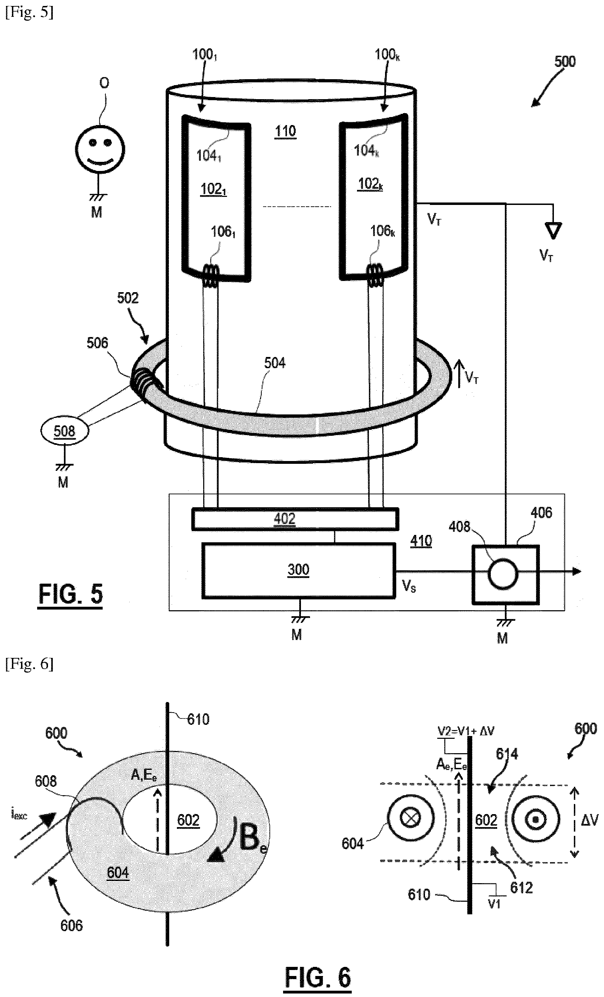

Dans l'exemple décrit sur la [Fig.4], la surface de référence 110 est polarisée au potentiel de travail $V_T$ par une source électrique 404 qui est reliée à ladite surface de référence 110. Alternativement, la surface de référence 110 eut être polarisée au potentiel de travail $V_T$ par induction en utilisant au moins un moyen de polarisation par induction, comme décrit ci-dessous en référence à la [Fig.5].

La [Fig.5] est une représentation schématique d'un autre exemple de réalisation non limitatif d'un dispositif de détection selon l'invention.

Le dispositif de détection 500, représenté sur la [Fig.5], comprend tous les éléments du dispositif 400 de la [Fig.4], sauf en ce qui concerne les différences décrites ci-dessous.

Dans le dispositif 500, la surface de référence 110 est polarisée au potentiel de travail $V_T$ par induction.

Pour ce faire, le dispositif de détection comprend au moins un module torique de polarisation 502 comprenant une ouverture centrale traversée par la surface de référence 110.

Dans l'exemple représenté, le module torique de polarisation 502 comprend :

- un noyau torique fermé 504, dit d'excitation, comportant une ouverture centrale et réalisant un circuit magnétique fermé autour de l'ouverture centrale ; et
- au moins un bobinage électrique 506, dit bobinage d'excitation, enroulé autour dudit noyau torique d'excitation 504, et alimenté par un signal électrique alternatif fourni par une source électrique 508.

Le noyau torique d'excitation 504 peut être de forme circulaire, et plus généralement une forme comportant une symétrie de révolution.

Le noyau torique d'excitation 504 peut être de section circulaire, parallélépipédique, triangulaire, etc.

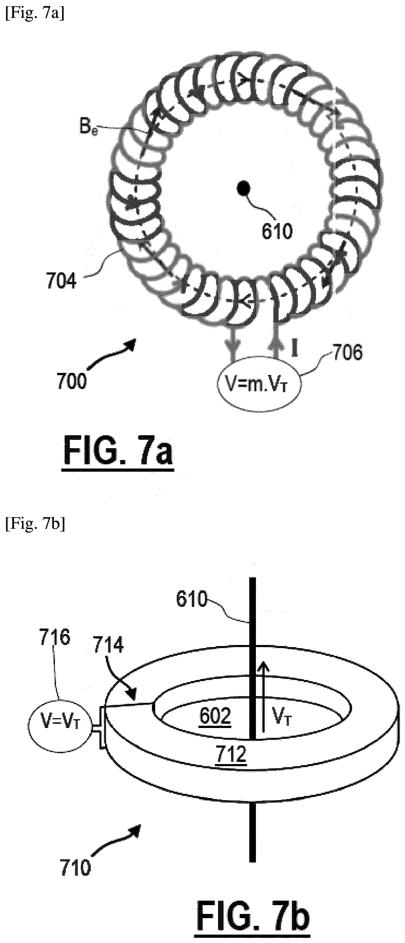

Le module torique de polarisation 502 n'est pas limité à l'exemple donné en [Fig.5] et d'autres architectures sont décrites à titre d'exemples non limitatifs en référence aux FIGURES 7a-7d.

Le module torique de polarisation 502 et en particulier, le bobinage d'excitation 506 est alimenté par une source d'excitation 508 et permet de générer une différence de potentiel $V_T$ le long de tous les éléments qui traversent l'ouverture centrale du module torique de polarisation 502. Le principe du module torique de polarisation est décrit plus bas en référence à la [Fig.6].

Le module torique de polarisation 502 permet ainsi par exemple de polariser toute une partie d'un appareil, par ailleurs référencé à un potentiel de masse M, au potentiel de travail $V_T$ de manière simple. En effet, il n'est alors plus nécessaire que la surface de référence 110 soit isolée électriquement des parties de l'appareil à la masse M, comme dans le mode de réalisation de la [Fig.4].

Le dispositif 500 diffère aussi du dispositif 400 de la [Fig.4] en ce que l'électronique de mesure 300 est référencée au potentiel de masse M, tout comme l'étage de détection 410 dans son ensemble.

Dans ce cas, les bobinages de captation des capteurs toriques $100_l$-$100_n$ sont reliés à l'électronique de mesure 300 par des liaisons électriques qui traversent également l'ouverture centrale du module torique d'excitation. Ainsi, le potentiel de référence de l'électronique de mesure 300, correspondant à la masse M, est porté par induction au potentiel de travail $V_T$ au niveau des bobinages de captation et ne perturbe donc pas la détection de l'objet O.

Le signal de mesure $V_S$ est démodulé comme précédemment pour en extraire son amplitude par un étage de démodulation synchrone utilisant comme porteuse le potentiel de travail alternatif $V_T$.

Dans l'exemple représenté, le potentiel $V_T$ peut être récupéré au niveau de la surface de référence 110 sans passer par le module torique de polarisation 502, et sans utiliser de source dédiée, tel que la source 404 de la [Fig.4], ces deux alternatives étant également possibles dans des variantes de réalisation.

Bien entendu, suivant des variantes, il est également possible de mettre en œuvre une électronique de mesure référencée au potentiel de travail $V_T$, comme décrit en référence à la [Fig.4], et la relier directement aux bobinages de captation $106_I$-$106_K$. On peut dans ce cas par exemple relier la sortie de l'électronique de mesure 300 au travers du module torique de polarisation, pour référencer le signal $V_s$ ainsi généré au potentiel de masse M.

La [Fig.6] est une représentation schématique du principe de fonctionnement d'un module torique de polarisation pouvant être mis en œuvre dans un dispositif de détection selon l'invention.

Le module torique de polarisation 600 est représenté d'une part selon une vue isométrique et d'autre part selon une vue de coupe sur la [Fig.6].

L'exemple donné sur la [Fig.6] n'est nullement limitatif. Le module torique de polarisation 600 peut présenter différentes architectures, dont des exemples non limitatifs seront décrits dans la suite en référence aux FIGURES 7a-7d.

Le module torique de polarisation 600 comporte une ouverture centrale 602.

Le module torique de polarisation 600 comprend un noyau ferromagnétique 604, dit noyau d'excitation, de section circulaire et de forme circulaire, par exemple en ferrite, autour duquel est enroulé un bobinage 606, dit d'excitation, comportant une unique spire 608.

Un conducteur électrique 610 traverse l'ouverture centrale 602 du module torique de polarisation 600. Le conducteur électrique 610 entre dans l'ouverture centrale 602 par une entrée 612 et sort de l'ouverture centrale 602 par une sortie 614. Ce conducteur électrique 610 peut être, par exemple, un câble électrique, ou une piste électrique, de liaison d'une électrode de mesure, ou une pièce conductrice de la structure d'un appareil.

La circulation d'un courant électrique alternatif « $i_{exc}$ », dans le bobinage d'excitation 606, génère un champ magnétique $B_e$ dans le module torique de polarisation 600. Ce champ magnétique $B_e$ est en circulation autour de l'ouverture centrale 602, espace dans lequel se trouve le conducteur électrique 610. Le champ magnétique $B_e$ est associé à un potentiel vecteur de champ magnétique, $A_e$, défini par $B_e = Rot(A_e)$ dans l'espace entouré par ce champ magnétique $B_e$. Une variation temporelle de ce potentiel vecteur de champ magnétique $A_e$ génère un champ électrique, $E_e$, suivant la même direction et selon la relation $E_e = -\dfrac{\partial A_e}{\partial t}$. Ce champ électrique $E_e$ va établir une différence de potentiel $\Delta V$, le long des lignes de champ définies par le potentiel vecteur $A_e$.

Par conséquent, l'élément conducteur 610, traversant l'ouverture centrale 602 contenant les lignes de champ, verra une différence de potentiel électrique $\Delta V$ apparaître entre ses sections respectivement en amont et en aval de cet espace, c'est-à-dire entre sa section se trouvant avant l'entrée 612 de l'ouverture centrale 602 et sa section se trouvant après la sortie 614 de l'ouverture centrale 602. En d'autres termes, par rapport à une référence quelconque telle qu'une masse générale, si le conducteur 610 est au potentiel V1 au niveau de l'entrée 612 de l'ouverture centrale 602, ce même conducteur 610 sera au potentiel V2=V1+$\Delta V$, au niveau de la sortie 614 du module torique de polarisation 600.

Il est à noter que cette différence de potentiel $\Delta V$ est superposée à tous les potentiels présents dans le conducteur 610 qui traverse le module torique de polarisation 600. Ainsi, par exemple, si le potentiel V1 est un potentiel de référence ou de masse générale de l'électronique en amont du module torique de polarisation 600, le potentiel V2 = V1+$\Delta V$, alternatif, devient le potentiel de référence en aval du module torique de polarisation 600.

Ainsi, il est possible de polariser tout conducteur traversant le module torique de polarisation 600 à un potentiel alternatif de travail, noté $V_T$, en choisissant $\Delta V = V_T$.

L'architecture du module torique de polarisation 600, représentée en sur la [Fig.6], n'est nullement limitative et est donnée à titre d'exemple.

La [Fig.7a] est une représentation schématique, vue de dessus, d'un exemple de réalisation non limitatif d'un module de polarisation d'un dispositif de détection selon l'invention.

Le module de polarisation 700, représenté sur la [Fig.7a], comprend un bobinage d'excitation 704 en forme de tore. Plus particulièrement, le bobinage d'excitation 704 présente une forme comportant une symétrie de révolution, en particulier circulaire.

Le bobinage d'excitation 704 présente une forme de section circulaire. Alternativement, le bobinage d'excitation 704 peut présenter une section triangulaire, carré, rectangulaire, etc.

Dans l'exemple représenté sur la [Fig.7a], le module torique de polarisation 700 ne comporte pas de noyau autour duquel est enroulé le bobinage d'excitation 704. Autrement dit, le bobinage d'excitation 704 est enroulé autour de l'air.

Suivant une alternative, le module torique de polarisation 700 peut comprendre un noyau autour duquel est enroulé le bobinage d'excitation 704. Dans ce cas, le noyau peut être réalisé dans un matériau ferromagnétique, ou dans un matériau qui n'est pas ferromagnétique.

Le module torique de polarisation 700 comprend en outre une source électrique 706 alimentant le bobinage d'excitation 704 par une tension alternative V. En supposant que le bobinage d'excitation 704 comprend « m » spires, pour induire une différence de potentiel alternatif égale à $V_T$ dans tout conducteur électrique 610 qui traverse ledit le module torique de polarisation 700, il faut alimenter le bobinage d'excitation 704 avec une tension $V=m.V_T$, en négligeant les pertes de couplage.

La [Fig.7b] est une représentation schématique d'un exemple de réalisation non limitatif d'un module torique de polarisation pouvant être mis en œuvre dans un dispositif de détection selon l'invention.

Le module de polarisation 710 comprend un noyau torique d'excitation 712 et un bobinage électrique d'excitation 714 enroulé autour d'un noyau ferromagnétique 716.

Dans l'exemple représenté, le bobinage d'excitation 714 comprend une unique spire. Bien entendu, le bobinage d'excitation 714 peut comprendre plus d'une spire.

Le module torique de polarisation 710 comprend en outre une source électrique 716 pour alimenter le bobinage d'excitation 714 par une tension alternative V.

Dans l'exemple représenté sur la [Fig.7b], en négligeant les pertes, une différence de potentiel alternative d'excitation $V=V_T$ est appliquée aux bornes du bobinage d'excitation 714 comprenant une spire unique. Ainsi, le module torique de polarisation 710 génère, dans tout conducteur électrique 610 qui traverse ledit module 710, une différence de potentiel $\Delta V=V_T$ entre l'entrée du module torique de polarisation 710 et la sortie du module torique de polarisation 710.

De manière générale, comme indiqué plus haut, si une tension V est appliquée aux bornes d'un bobinage électrique de « m » spires enroulées autour du noyau 712, la différence de potentiel induit sur le conducteur électrique 610 traversant le module torique de polarisation 710 serait de $\Delta V=V/m$. Par conséquent, si une différence de potentiel $V_T$ est souhaitée sur le conducteur 610 avec un bobinage d'excitation comprenant « m » spires enroulées autour du noyau 712, alors ledit bobinage d'excitation doit être alimentée par une tension $V=m.V_T$.

De plus, selon une définition générale, la source de tension 716 fournissant la tension V « voit » une impédance qui dépend de l'inductance du bobinage électrique, qui augmente avec le nombre de spires et la surface englobée par la ou les spires. L'inductance $L_m$ d'un bobinage électrique de « m » spires est ainsi $L_m = m^2 L$, avec L l'inductance d'une spire de même surface.

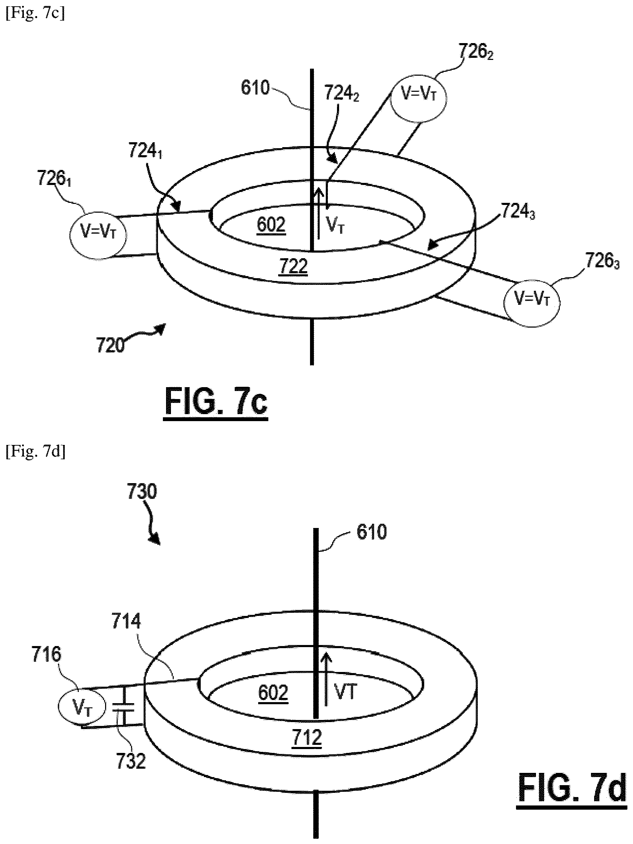

La [Fig.7c] est une représentation schématique d'un autre exemple de réalisation non limitatif d'un module torique de polarisation pouvant être mis en œuvre dans un dispositif de détection selon l'invention.

Le module torique de polarisation 720 de la [Fig.7c] comprend un noyau torique d'excitation ferromagnétique 722 et trois bobinages d'excitations $724_1$-$724_3$ distincts, enroulés autour dudit noyau torique ferromagnétique 722.

Dans l'exemple représenté, chaque bobinage d'excitation $724_1$-$724_3$ comprend une unique spire. Bien entendu, au moins un des bobinages d'excitation $724_1$-$724_3$ peut comprendre plus d'une spire.

Les bobinages d'excitation $724_1$-$724_3$ sont identiques. Alternativement, au moins deux des bobinages d'excitation $724_1$-$724_3$ peuvent être différents. Dans ce cas, les bobinages d'excitation comportant différents nombres de spires sont alimentés par différentes tensions alternatives.

Sur la [Fig.7c], les bobinages d'excitation $724_1$-$724_3$ sont disposés selon un pas angulaire constant de 120° pour assurer une meilleure répartition du champ magnétique $B_e$. Bien entendu, selon des alternatives, le pas angulaire entre les bobinages d'excitation peut ne pas être constant.

En outre, le module torique d'excitation 720 peut comprendre un nombre de bobinages d'excitation différent de trois.

Dans l'exemple représenté sur la [Fig.7c], chaque bobinage d'excitation $724_1$-$724_3$ est alimenté par une tension $V=V_T$ de sorte qu'une différence de potentiel alternatif égale à $V_T$ est générée dans tout conducteur électrique 610 qui traverse le noyau torique d'excitation 722, puisque chaque bobinage électrique $724_1$-$724_3$ comporte une unique spire. Selon une définition générale, dans l'exemple de la [Fig.7c], si au moins un des bobinages d'excitation comprend « m » spires, alors il faudrait alimenter ledit bobinage d'excitation par une tension alternative $V=V_T.m$, pour générer une différence de potentiel alternatif égale à $V_T$ dans tout conducteur électrique 610 qui traverse le noyau torique d'excitation 722.

Le module torique de polarisation 720 comprend, pour chaque bobinage électrique $724_1$-$724_3$, une source électrique, respectivement $726_1$-$726_3$, dédié à l'alimentation dudit bobinage d'excitation. Alternativement, au moins deux, en particulier tous les, bobinages électriques $724_1$-$724_3$ peuvent être alimentés par une unique source électrique commune à l'ensemble desdits bobinages électriques.

Il est à noter que, pour « p » bobinages d'excitation distincts autour d'un même noyau d'excitation ferromagnétique, du fait des couplages par mutuelle inductance, l'inductance $L_p$ de chaque bobinage d'excitation est donnée par $L_p=pL$, avec L l'inductance d'un bobinage d'excitation qui serait seul autour dudit noyau. Ainsi, l'inductance de p bobinages d'excitations en parallèle, alimentés par une même source électrique, correspond à : $pL/p=L$, soit la même inductance que celle d'un bobinage unique. La puissance consommée par « p » bobinages d'excitation est donc la même que la puissance consommée par un seul bobinage d'excitation.

La [Fig.7d] est une représentation schématique d'un autre exemple de réalisation non limitatif d'un module torique de polarisation pouvant être mis en œuvre dans un dispositif de détection selon l'invention.

Le module torique de polarisation 730 de la [Fig.7d] comprend tous les éléments du module torique de polarisation 710 de la [Fig.7b].

Le module torique d'excitation 730 comprend en outre un condensateur 732 en parallèle avec le bobinage d'excitation 714, de sorte que le bobinage d'excitation 714 forme, avec ledit condensateur 732, un circuit résonant. La capacité du condensateur 732 et la valeur de l'inductance du bobinage d'excitation 714 sont choisies de sorte que la fréquence de résonance du circuit résonnant soit égale à la fréquence de travail, notée $f_T$, c'est-à-dire à la fréquence du potentiel de travail $V_T$.

La mise en résonance, via l'ajout d'un condensateur 732, permet d'augmenter l'impédance et donc de réduire le courant d'alimentation du bobinage d'excitation 714. Dans ce cas, la source électrique 716 doit être accordée à la fréquence $f_T$ donnée par la relation suivante $f_T = \dfrac{1}{2\pi\sqrt{C.L_{eq}}}$, avec C la capacité du condensateur 732 et $L_{eq}$ l'inductance résultante.

Cette configuration, illustrée à la [Fig.7d] avec un unique bobinage d'excitation peut bien entendu être utilisée dans chacun des exemples donnés aux FIGURES 7a-7c, avec chacun des modules toriques d'excitation 700, 710 et 720.

L'inductance de chacun des bobinages d'excitation, avec « p » enroulements, est $L_p = pL$, avec L l'inductance d'un bobinage d'excitation qui serait seul autour d'un noyau torique. Si C est la capacité pour obtenir une résonance à la fréquence d'excitation $f_T$ avec un unique bobinage d'excitation d'inductance L, la capacité $C_p$ à mettre en parallèle avec chacun des p enroulements couplés pour obtenir la même fréquence de résonnance est $C_p = C/p$, ce qui donne

$$f_T = \frac{1}{2\pi\sqrt{\dfrac{C}{p}.p.L}}.$$

Chacun des modules toriques de polarisation 700, 710, 720 et 730 qui viennent d'être décrits comprennent un unique noyau torique d'excitation qui est soit formé par un noyau ferromagnétique soit formé par un bobinage d'excitation.

Alternativement, un module torique de polarisation peut comprendre plusieurs modules toriques d'excitation, identiques ou différents, mis en cascade.

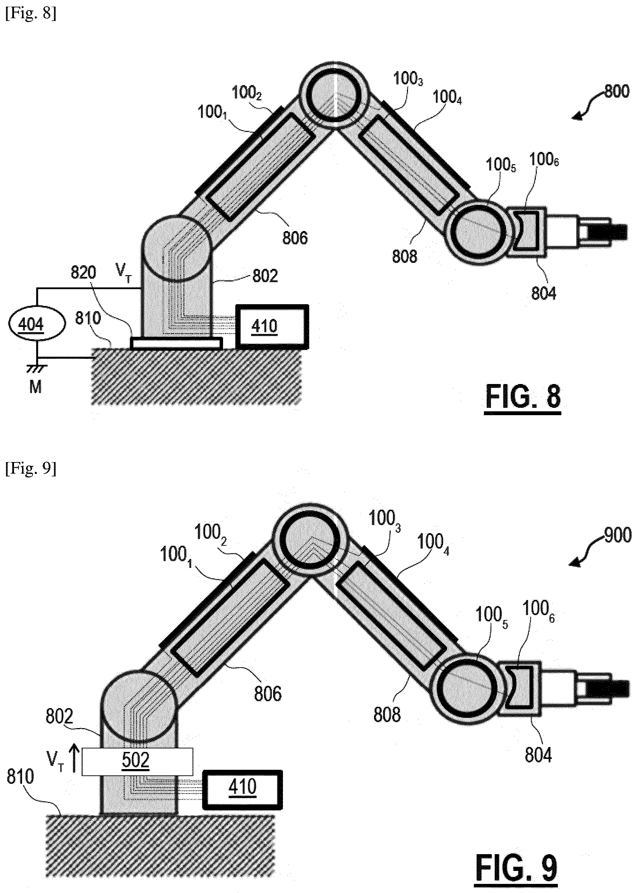

La [Fig.8] est une représentation schématique d'un exemple de réalisation non limitatif d'un appareil selon l'invention.

L'appareil 800, représenté sur la [Fig.8], est un bras robotisé comportant un segment de base 802 et un segment distal 804 équipé d'une tête fonctionnelle, qui peut par exemple être un organe de préhension motorisé. Le bras robotisé 800 comporte deux autres segments intermédiaires 806 et 808 disposés entre le segment de base 802 et le segment distal 804.

Le bras robotisé 800 est disposé sur une surface 810, qui est au potentiel de masse M. Il est électriquement isolé de cette surface 810 par un élément d'isolation 820, et polarisée au potentiel de travail $V_T$ par une source électrique 404.

Le bras robotisé 800 est équipé d'un dispositif de détection selon l'invention, qui peut être de manière nullement limitative, le dispositif de détection 400 de la [Fig.4].

Ainsi, le bras robotisé 800 comprend un ou plusieurs capteurs toriques $100_1$-$100_6$ disposés sur les surfaces externes des éléments d'habillage du bras robotisé 800 et reliés à l'électronique de détection 410. Sur la [Fig.8], le dispositif de détection 400 est représenté partiellement. Ainsi, seul les capteurs toriques $100_i$ et l'électronique de détection 410 sont visibles.

Chaque capteur torique $100_i$ équipant le bras robotisé 800 peut être n'importe quel des capteurs 100, 200, 210, 220, 230 décrits plus haut en référence aux FIGURES 1, 2a-2b. Dans l'exemple illustré, les surfaces de références de ces capteurs sont les surfaces externes des éléments d'habillage du bras robotisé, conducteurs et polarisés au potentiel de travail $V_T$ par la source électrique 404.

La [Fig.9] est une représentation schématique d'un autre exemple de réalisation non limitatif d'un appareil selon l'invention.

L'appareil 900, représenté sur la [Fig.9], est un bras robotisé comportant, comme le robot 800 de la [Fig.8], un segment de base 802 et un segment distal 804 équipé d'une tête fonctionnelle, qui peut par exemple être un organe de préhension motorisé, et deux autres segments intermédiaires 806 et 808 disposés entre le segment de base 802 et le segment distal 804.

Le bras robotisé 900 est disposé sur une surface 810, qui est au potentiel de masse M.

Le bras robotisé 900 est équipé d'un dispositif de détection selon l'invention, qui peut être de manière nullement limitative, le dispositif de détection 500 de la [Fig.5].

Ainsi, le bras robotisé 900 comprend un ou plusieurs capteurs toriques $100_1$-$100_6$ disposés sur/dans les surfaces externes des éléments d'habillage du bras robotisé 900 et reliés à l'électronique de détection 410. Chaque capteur torique

$100_i$ équipant le bras robotisé 800 peut être n'importe quel des capteurs 100, 200, 210, 220, 230 décrits plus haut en référence aux [Fig.1], 2a-2b.

De plus, le robot 900 comporte le module torique de polarisation 502. Le module de polarisation 502, et en particulier le noyau torique d'excitation 504, est disposé autour du segment de base 802 du bras robotisé 900. Ainsi, l'ensemble des conducteurs d'électricité qui traversent le noyau torique d'excitation 504, ainsi que tous les conducteurs électriques qui sont au contact de ces derniers, sont polarisés au potentiel de travail $V_T$, en aval dudit module torique de polarisation 502. En particulier, toute la partie du bras robotisé 900 qui se trouve en aval du module torique de polarisation 502 est polarisée au potentiel de travail $V_T$. Dans l'exemple illustré, les surfaces de références des capteurs toriques $100_1$-$100_6$ sont les surfaces externes des éléments d'habillage du bras robotisé, conducteurs et polarisés au potentiel de travail $V_T$ par le module torique de polarisation 502.

Le module torique de polarisation 502 équipant le bras robotisé 900 peut être n'importe quel des capteurs 600, 700, 710, 720, 730 décrits plus haut en référence aux FIGURES 6, 7a-7d.

Bien entendu, l'invention n'est pas limitée aux exemples détaillés ci-dessus.

## Revendications

1. Dispositif (400;500) de détection de couplage capacitif entre au moins un objet (O) et une surface (110), dite de référence, électriquement conductrice, ledit dispositif (400;500) comprenant :

   - au moins un moyen (404;502), dit de polarisation, prévu pour créer, entre ladite surface de référence (110) et ledit objet (O) à détecter, une différence de potentiel électrique alternative ($V_T$), dite de travail, générant un champ électrique alternatif entre ladite surface de référence (110) et ledit objet (O), et
   - une électronique de mesure (300) ;

   ledit dispositif comprenant en outre, distinct dudit au moins un moyen de polarisation, au moins un capteur torique (100;200;210) :

   - comportant une ouverture centrale (102) prévue pour être traversée par ledit champ électrique alternatif (112,E) qui y génère un champ magnétique circulaire (B), et
   - étant prévu pour fournir un signal électrique (i) induit par ledit champ magnétique circulaire (B), et représentatif dudit champ électrique alternatif (112,E) ;

   ladite électronique de mesure (300) étant configurée pour détecter ledit signal électrique induit (i) fourni par ledit capteur torique (100;200;210).

2. Dispositif (400;500) selon la revendication précédente, **caractérisé en ce qu'**il comprend plusieurs capteurs toriques ($100_1$-$100_k$).

3. Dispositif (400;500) selon l'une quelconque des revendications précédentes, **caractérisé en ce qu'**au moins un capteur torique (400;500) comprend :

   - un noyau torique (104;214), dit de captation, comportant l'ouverture centrale (102) et formant un circuit magnétique fermé autour de ladite ouverture centrale (102) ; et
   - au moins un bobinage électrique (106 ;216), dit bobinage de captation, enroulé autour dudit noyau torique de captation (104;214), dans lequel est induit le signal électrique (i) induit.

4. Dispositif (400;500) selon la revendication précédente, **caractérisé en ce que** le noyau torique de captation (104;214) est un noyau ferromagnétique, formant un circuit magnétique fermé autour de l'ouverture centrale (102), et autour duquel est enroulé l'au moins un bobinage de captation (106;216).

5. Dispositif selon l'une quelconque des revendications 3 ou 4, **caractérisé en ce qu'**au moins un capteur torique comprend plusieurs bobinages de captation.

6. Dispositif (400;500) selon l'une quelconque des revendications précédentes, **caractérisé en ce qu'**au moins un capteur torique (200) comprend, ou est formé par :

   - un bobinage électrique (204), dit de captation, de forme torique, fermé sur lui-même ou semi-fermé, formant un circuit magnétique fermé autour de l'ouverture centrale (102), et dans lequel est induit le signal électrique induit ;

ou

- plusieurs bobinages, dits de captation, formant ensemble un contour torique, fermé sur lui-même ou semi-fermé, formant un circuit magnétique fermé autour de l'ouverture centrale, et dans lesquels est induit le signal électrique induits.

**7.** Dispositif (400;500) selon l'une quelconque des revendications 3 à 6, **caractérisé en ce qu'**au moins un bobinage de captation (106;216) d'un capteur torique (100;200;210) est formé par :

- une unique spire (108), partielle ou totale, ou
- plusieurs spires ;

traversant l'ouverture centrale (102) du capteur torique (100;200;210).

**8.** Dispositif (400;500) selon l'une quelconque des revendications précédentes, **caractérisé en ce que** l'électronique de mesure (300) comprend un amplificateur de tension (304), ou de transimpédance, relié à au moins un capteur torique (100;200;210), et fournissant en sortie une tension ($V_s$) relative au signal électrique (i) induit fourni par ledit capteur torique.

**9.** Dispositif (400;500) selon l'une quelconque des revendications précédentes, **caractérisé en ce qu'**il comprend en outre au moins une surface de référence (110) en regard de laquelle est agencé au moins un capteur torique (100;200;210).

**10.** Dispositif (400;500) selon la revendication précédente, **caractérisé en ce qu'**au moins un capteur torique (100;200;210) est :

- inscrit dans un plan, ou une surface, se conformant à la surface de référence (110),
- posé sur la surface de référence (110), et/ou
- en regard de la surface de référence (110), à distance de ladite surface de référence (110).

**11.** Dispositif (400) selon la revendication précédente, **caractérisé en ce que** le moyen de polarisation comprend au moins une source électrique (404) reliée à la surface de référence (110) et/ou à l'objet à détecter (O).

**12.** Dispositif (500) selon l'une quelconque des revendications précédentes, **caractérisé en ce que** le moyen de polarisation comprend au moins un module de polarisation torique (502;600;700;710;720;730), chaque module de polarisation torique (502;600;700;710;720;730) :

- comprenant une ouverture centrale (602), prévue pour être disposée autour d'au moins un conducteur électrique (610) en liaison électrique avec ladite surface de référence (110), et
- étant prévu pour être alimenté par un signal électrique alternatif, dit d'excitation, agencé pour générer un champ magnétique circulaire ($B_e$) dans ledit module torique de polarisation et un potentiel vecteur champ électrique axial dans ladite ouverture centrale (602) ;

de sorte à induire, dans ledit conducteur électrique (610) traversant l'ouverture centrale (602), la différence de potentiel électrique alternative de travail ($V_T$).

**13.** Équipement pour un appareil, comprenant un dispositif (400;500) de détection de couplage capacitif selon l'une quelconque des revendications précédentes.

**14.** Appareil (800;900) comportant :

- un dispositif de détection (400;500) selon l'une quelconque des revendications 1 à 12 ; et/ou
- un équipement selon la revendication précédente.

**15.** Appareil (800;900) selon la revendication précédente, **caractérisé en ce qu'**il s'agit d'un robot ou d'une partie de robot, mobile ou fixe.

**Patentansprüche**

1. Vorrichtung (400; 500) zur Erkennung einer kapazitiven Kopplung zwischen mindestens einem Objekt (O) und einer elektrisch leitfähigen Fläche (110), die als Referenzfläche bezeichnet wird, wobei die Vorrichtung (400; 500) Folgendes umfasst:

   - mindestens ein Mittel (404; 502), das als Polarisationsmittel bezeichnet wird, das vorgesehen ist, um zwischen der Referenzfläche (110) und dem zu erkennenden Objekt (O) eine elektrische Wechselpotentialdifferenz ($V_T$), die als elektrische Arbeitswechselpotentialdifferenz bezeichnet wird, zu erzeugen, die ein elektrisches Wechselfeld zwischen der Referenzfläche (110) und dem Objekt (O) erzeugt, und
   - eine elektronische Messeinrichtung (300);
   wobei die Vorrichtung ferner, getrennt von dem mindestens einen Polarisationsmittel, mindestens einen torusförmigen Sensor (100; 200; 210) umfasst:

      - umfassend eine zentrale Öffnung (102), die vorgesehen ist, um von dem elektrischen Wechselfeld (112, E) durchsetzt zu werden, das darin ein kreisförmiges Magnetfeld (B) erzeugt, und
      - vorgesehen, um ein elektrisches Signal (i) bereitzustellen, das durch das kreisförmige Magnetfeld (B) induziert wird und für das elektrische Wechselfeld (112, E) repräsentativ ist;

   wobei die elektronische Messeinrichtung (300) konfiguriert ist, um das induzierte elektrische Signal (i) zu erkennen, das von dem torusförmigen Sensor (100; 200; 210) bereitgestellt wird.

2. Vorrichtung (400; 500) nach dem vorstehenden Anspruch, **dadurch gekennzeichnet, dass** sie mehrere torusförmige Sensoren ($100_1$-$100_k$) umfasst.

3. Vorrichtung (400; 500) nach einem der vorstehenden Ansprüche, **dadurch gekennzeichnet, dass** mindestens ein torusförmiger Sensor (400; 500) Folgendes umfasst:

   - einen Ringkern (104; 214), der als Erfassungsringkern bezeichnet wird, der die zentrale Öffnung (102) aufweist und einen geschlossenen Magnetkreis um die zentrale Öffnung (102) bildet; und
   - mindestens eine elektrische Wicklung (106; 216), die als Erfassungswicklung bezeichnet wird, die um den Erfassungsringkern (104; 214) gewickelt ist, in der das induzierte elektrische Signal (i) induziert wird.

4. Vorrichtung (400; 500) nach dem vorstehenden Anspruch, **dadurch gekennzeichnet, dass** der Erfassungsringkern (104; 214) ein ferromagnetischer Kern ist, der einen geschlossenen Magnetkreis um die zentrale Öffnung (102) bildet und um den die mindestens eine Erfassungswicklung (106; 216) gewickelt ist.

5. Vorrichtung nach einem der Ansprüche 3 oder 4, **dadurch gekennzeichnet, dass** mindestens ein torusförmiger Sensor mehrere Erfassungswicklungen umfasst.

6. Vorrichtung (400; 500) nach einem der vorstehenden Ansprüche, **dadurch gekennzeichnet, dass** mindestens ein torusförmiger Sensor (200) Folgendes umfasst oder gebildet ist durch:

   - eine elektrische Wicklung (204), die als Erfassungswicklung bezeichnet wird, in einer in sich geschlossenen oder halbgeschlossenen Ringform, die einen geschlossenen Magnetkreis um die zentrale Öffnung (102) bildet und in der das induzierte elektrische Signal induziert wird; oder
   - mehrere Wicklungen, die als Erfassungswicklungen bezeichnet werden, die zusammen eine in sich geschlossene oder halbgeschlossene torusförmige Kontur bilden, die einen geschlossenen Magnetkreis um die zentrale Öffnung bilden und in denen das induzierte elektrische Signal induziert wird.

7. Vorrichtung (400; 500) nach einem der Ansprüche 3 bis 6, **dadurch gekennzeichnet, dass** mindestens eine Erfassungswicklung (106; 216) eines torusförmigen Sensors (100; 200; 210) gebildet ist durch:

   - eine einzige teilweise oder vollständige Windung (108), oder
   - mehrere Windungen;

   die durch die zentrale Öffnung (102) des torusförmigen Sensors (100; 200; 210) verlaufen.

**8.** Vorrichtung (400; 500) nach einem der vorstehenden Ansprüche, **dadurch gekennzeichnet, dass** die elektronische Messeinrichtung (300) einen Spannungsverstärker (304) oder Transimpedanzverstärker umfasst, der mit mindestens einem torusförmigen Sensor (100; 200; 210) verbunden ist und am Ausgang eine Spannung ($V_s$) bezüglich des induzierten elektrischen Signals (i) liefert, das von dem torusförmigen Sensor bereitgestellt wird.

**9.** Vorrichtung (400;500) nach einem der vorstehenden Ansprüche, **dadurch gekennzeichnet, dass** sie ferner mindestens eine Referenzfläche (110) umfasst, gegenüber der mindestens ein torusförmiger Sensor (100;200;210) angeordnet ist.

**10.** Vorrichtung (400; 500) nach dem vorstehenden Anspruch, **dadurch gekennzeichnet, dass** mindestens ein torusförmiger Sensor (100; 200; 210):

- in eine Ebene oder eine Fläche einbeschrieben ist, die sich an die Referenzfläche (110) anpasst,
- auf der Referenzfläche (110) angeordnet ist, und/oder
- gegenüber der Referenzfläche (110), beabstandet von der Referenzfläche (110) ist.

**11.** Vorrichtung (400) nach dem vorstehenden Anspruch, **dadurch gekennzeichnet, dass** das Polarisationsmittel mindestens eine elektrische Quelle (404) umfasst, die mit der Referenzfläche (110) und/oder dem zu erkennenden Objekt (O) verbunden ist.

**12.** Vorrichtung (500) nach einem der vorstehenden Ansprüche, **dadurch gekennzeichnet, dass** das Polarisationsmittel mindestens ein torusförmiges Polarisationsmodul (502; 600; 700; 710; 720; 730) umfasst, wobei jedes torusförmige Polarisationsmodul (502; 600; 700; 710; 720; 730):

- eine zentrale Öffnung (602) umfasst, die vorgesehen ist, um mindestens um einen elektrischen Leiter (610) herum in elektrischer Verbindung mit der Referenzfläche (110) angeordnet zu werden, und
- vorgesehen ist, um mit einem elektrischen Wechselsignal, das als Erregungssignal bezeichnet wird, gespeist zu werden, das ausgebildet ist, um ein kreisförmiges Magnetfeld ($B_e$) in dem genannten torusförmigen Polarisationsmodul und ein axiales elektrisches Feldvektorpotential in der zentralen Öffnung (602) zu erzeugen;

um in dem elektrischen Leiter (610), der durch die zentrale Öffnung (602) verläuft, die elektrische Arbeitswechselpotentialdifferenz ($V_T$) zu induzieren.

**13.** Gerät für eine Einrichtung, umfassend eine Vorrichtung (400; 500) zur Erkennung einer kapazitiven Kopplung nach einem der vorstehenden Ansprüche.

**14.** Einrichtung (800; 900), umfassend:

- eine Erkennungsvorrichtung (400; 500) nach einem der Ansprüche 1 bis 12; und/oder
- ein Gerät nach dem vorstehenden Anspruch.

**15.** Einrichtung (800; 900) nach dem vorstehenden Anspruch, **dadurch gekennzeichnet, dass** es sich um einen Roboter oder um einen Teil eines Roboters, mobil oder stationär, handelt.

**Claims**

**1.** Device (400;500) for detecting capacitive coupling between at least one object (O) and an electrically conductive surface (110), referred to as a reference surface, said device (400;500) comprising:

- at least one means (404;502), referred to as a polarization means, designed to create, between said reference surface (110) and said object (O) to be detected, an alternating electric potential difference ($V_T$), referred to as a working potential difference, generating an alternating electric field between said reference surface (110) and said object (O), and
- measurement electronics (300);
said device further comprising, separate from said at least one polarization means, at least one toroidal sensor (100;200;210):

- having a central aperture (102) designed to be passed through by said alternating electric field (112,E) which generates a circular magnetic field (B) therein, and
- being designed to supply an electrical signal (i) induced by said circular magnetic field (B) and representative of said alternating electric field (112,E);

said measurement electronics (300) being configured to detect said induced electrical signal (i) supplied by said toroidal sensor (100;200;210).

2. Device (400;500) according to the preceding claim, **characterized in that** it comprises a plurality of toroidal sensors ($100_1$-$100_k$).

3. Device (400;500) according to any one of the preceding claims, **characterized in that** at least one toroidal sensor (400;500) comprises:

- a toroidal core (104;214), referred to as a sensing core, having the central aperture (102) and forming a closed magnetic circuit around said central aperture (102); and
- at least one electrical coil (106;216), referred to as a sensing coil, wound around said toroidal sensing core (104;214), in which the induced electrical signal (i) is induced.

4. Device (400;500) according to the preceding claim, **characterized in that** the toroidal sensing core (104;214) is a ferromagnetic core forming a closed magnetic circuit around the central aperture (102) and around which the at least one sensing coil (106;216) is wound.

5. Device according to any of claims 3 or 4, **characterized in that** at least one toroidal sensor comprises a plurality of sensing coils.

6. Device (400;500) according to any one of the preceding claims, **characterized in that** at least one toroidal sensor (200) comprises, or is formed by:

- a self-closed or semi-closed toroidal electrical coil (204), referred to as a sensing coil, forming a closed magnetic circuit around the central aperture (102) and in which the induced electrical signal is induced; or
- a plurality of coils, referred to as sensing coils, together forming a self-closed or semi-closed toroidal contour, forming a closed magnetic circuit around the central aperture, and in which the induced electrical signal is induced.

7. Device (400;500) according to any of claims 3 to 6, **characterized in that** at least one sensing coil (106;216) of a toroidal sensor (100;200;210) is formed by:

- a single partial or total turn (108), or
- a plurality of turns;

passing through the central aperture (102) of the toroidal sensor (100;200;210).

8. Device (400;500) according to any one of the preceding claims, **characterized in that** the measurement electronics (300) comprise a voltage amplifier (304), or transimpedance amplifier, connected to at least one toroidal sensor (100;200;210) and supplying as output a voltage ($V_s$) relative to the electrical signal (i) induced by said toroidal sensor.

9. Device (400;500) according to any one of the preceding claims, **characterized in that** it further comprises at least one reference surface (110) opposite which at least one toroidal sensor (100;200;210) is arranged.

10. Device (400;500) according to the preceding claim, **characterized in that** at least one toroidal sensor (100;200;210) is:

- inscribed in a plane, or surface, conforming to the reference surface (110),
- placed on the reference surface (110), and/or
- facing the reference surface (110), at a distance from said reference surface (110).

11. Device (400) according to the preceding claim, **characterized in that** the polarization means comprises at least one electrical source (404) connected to the reference surface (110) and/or to the object (O) to be detected.

12. Device (500) according to any of the preceding claims, **characterized in that** the polarization means comprises at least one toroidal polarization module (502;600;700;710;720;730), each toroidal polarization module (502;600;700;710;720;730):

   - comprising a central aperture (602) designed to be arranged around at least one electrical conductor (610) in electrical connection with said reference surface (110), and
   - being designed to be supplied with an alternating electrical signal, referred to as an excitation signal, arranged to generate a circular magnetic field ($B_e$) in said toroidal polarization module and an axial electric field vector potential in said central aperture (602);

   so as to induce, in said electrical conductor (610) passing through the central aperture (602), the working alternating electric potential difference ($V_T$).

13. Equipment item for an apparatus, comprising a capacitive coupling detection device (400;500) according to any one of the preceding claims.

14. Apparatus (800;900) having:

   - a detection device (400;500) according to any of claims 1 to 12; and/or
   - an equipment item according to the preceding claim.

15. Apparatus (800;900) according to the preceding claim, **characterized in that** it is a mobile or fixed robot or robot part.

[Fig. 1]

FIG. 1

[Fig. 2a]

FIG. 2a

[Fig. 2b]

V1

0

210

112, Eс

216

214

102

102

110

V2

# FIG. 2b

[Fig. 3]

300

302

306

100

i$_{cap}$

304

102

V$_s$

# FIG. 3

V$_T$

[Fig. 4]

**FIG. 4**

[Fig. 5]

**FIG. 5**

[Fig. 6]

**FIG. 6**

[Fig. 7a]

$B_e$

610

704

700

$V=m.V_T$

I

706

## FIG. 7a

[Fig. 7b]

610

716   714

$V=V_T$

602   $V_T$

712

710

## FIG. 7b

[Fig. 7c]

**FIG. 7c**

[Fig. 7d]

**FIG. 7d**

[Fig. 8]

FIG. 8

[Fig. 9]

FIG. 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2683084 A2